# FASCICULE DE BREVET EUROPEEN

(11) **EP 0 440 528 B1**
(45) Date de publication et mention de la délivrance du brevet: **19.04.1995**
(21) Numéro de dépôt: 91400166.4
(22) Date de dépôt: 25.01.1991
(51) Int. Cl.: H05K 7/14, H01R 23/68

(54) **Dispositif de fixation de cartes de circuits imprimés dans un boîtier, et boîtier équipé d'un tel dispositif**
Vorrichtung zur Befestigung von Leiterplatten in einem Gehäuse und Gehäuse, das mit einer derartigen Vorrichtung versehen ist
Fastening device for printed circuit boards in a case and case equipped with such a device

(30) Priorité: 26.01.1990 FR 9000907
(43) Date de publication de la demande: 07.08.1991
(73) Titulaire: R. ALKAN & Cie., 94460 Valenton (FR)
(72) Inventeur: Mattei, Jean-Pierre, F-94210 La Varenne (FR)
(74) Mandataire: Hud, Robert

(56) Documents cités:
- EP-A- 0 151 253
- EP-A- 0 154 420
- FR-A- 2 575 024
- US-A- 3 975 805

## Description

L'invention concerne l'industrie électronique et, plus particulièrement, la fixation de cartes de circuits imprimés dans des boîtiers.

Pour regrouper les cartes de circuits imprimés, on réalise habituellement des boîtiers parallélépipèdiques avec des glissières parallèles équidistantes par paires recevant chacune une carte que l'on introduit par un couvercle du boîtier et que l'on pousse jusqu'à ce que son connecteur, placé en avant, vienne s'enficher dans une plaque de connexion fixée au fond du boîtier. D'autre part des orifices du boîtier permettent un refroidissement des cartes par un courant d'air entre celles-ci, avec éventuellement une tôle perforée ou grille de répartition de cet air.

Lorsque des vibrations sont possibles, il convient de fixer positivement les cartes, tout au moins le long des glissières. On utilise par exemple à cet effet des ressorts d'appui à lames courbées, qui sont disposés pour appuyer chaque carte contre sa glissière; (voir par exemple US-A-3 975 805).

On connaît aussi des fixations par pincement sous contrainte au moyen de vis. Dans le dispositif connu par exemple sous la marque "LOK-TRAINER" commercialisé par la Société BIRTCHER, un profil ouvert supporte une lame ondulée qu'une vis d'extrémité met sous contrainte en repoussant les ondulations contre la carte. Ceci conduit à une masse assez importante.

Dans les cas extrêmes, on intègre la carte à un cadre métallique qui est lui-même fixé par une série de vis dans le boîtier. Ces cartes étant alors empilées et non pas glissées, elles ne sont plus indépendantes et l'ensemble devient en outre très lourd.

La présente invention a pour objet de remédier aux inconvénients présentés par les dispositifs connus. Elle permet de réaliser des boîtiers de cartes de circuits imprimés plus légers que ceux qui existent actuellement, avec néanmoins une fixation des cartes qui soit sans jeu et qui permette à l'ensemble de résister aux contraintes de vibrations, chocs et variations de températures en particulier pour les véhicules et spécialement pour ceux de l'industrie aéronautique ou spatiale.

Dans ce but, l'invention propose un dispositif de fixation énoncé dans la revendication 1 et un boîtier énoncé dans la revendication 9.

Selon l'invention on utilise de façon connue, pour la fixation des cartes de circuits imprimés, des glissières parallèles comprenant chacune deux surfaces planes dites lèvres qui peuvent recevoir les cartes par glissement et des dispositifs de pincement qui permettent de serrer chacune des cartes le long de son bord entre les deux lèvres en vis-à-vis de chacune des glissières, et l'invention se caractérise en ce que les glissières sont constituées par des replis de plaques ou voiles minces et souples, chaque boîtier recevant deux plaques en vis-à-vis le long de deux de ses parois latérales.

Un boîtier équipé selon l'invention comporte une caisse parallélépipèdique munie d'un couvercle, d'un fond à l'opposé du couvercle et de côtés latéraux, et il se caractérise par deux voiles minces et souples qui comportent des séries de replis dont chacun forme deux lèvres parallèles aptes à recevoir entre elles un des bords d'une carte, chaque voile étant maintenu à proximité d'un des côtés de la caisse, à une distance de l'autre voile correspondant à la largeur des cartes, et par des dispositifs de pincement permettant de serrer individuellement chaque bord de carte entre les lèvres parallèles de chaque repli de voile.

De préférence, le serrage a lieu, de part et d'autre du bord de la carte, par un rapprochement des lèvres du repli formant glissière permis par la souplesse du voile mince, avec flexion de celui-ci au droit du repli.

Suivant un mode de réalisation du dispositif selon l'invention le repli laisse entre les deux lèvres de glissière un léger jeu de part et d'autre de la carte, et le voile a une forme arquée entre deux glissières de sorte qu'un moyen d'aplatissement de cette forme arquée repousse les lèvres de glissière qui lui sont contiguës, ce qui les rapproche des lèvres en vis-à-vis en créant un serrage simultané de deux cartes précédemment introduites dans les deux glissières.

Selon un autre mode de réalisation le repli est fabriqué plus étroit pour obtenir au repos un serrage du repli sur les bords de la carte, et celle-ci est introduite (ou retirée) après action d'un dispositif qui accentue une forme arquée du voile entre deux glissières, ce qui écarte l'une de l'autre les deux lèvres en vis-à-vis.

Pour bien faire comprendre l'invention on en décrira ci-après, à titre d'exemples, deux formes d'exécution préférées en référence au dessin schématique annexé dans lequel :
la figure 1 est une vue en perspective d'une première forme d'exécution d'un dispositif de fixation de cartes de circuits imprimés selon l'invention ;
la figure 2 est une vue en perspective, avec arrachements. d'une portion d'un boîtier équipé du dispositif de fixation de la figure 1 ; et
la figure 3 montre, en vue perspective, un détail d'une seconde forme d'exécution du dispositif de fixation selon l'invention destiné à être monté dans un boîtier analogue à celui de la figure 2.

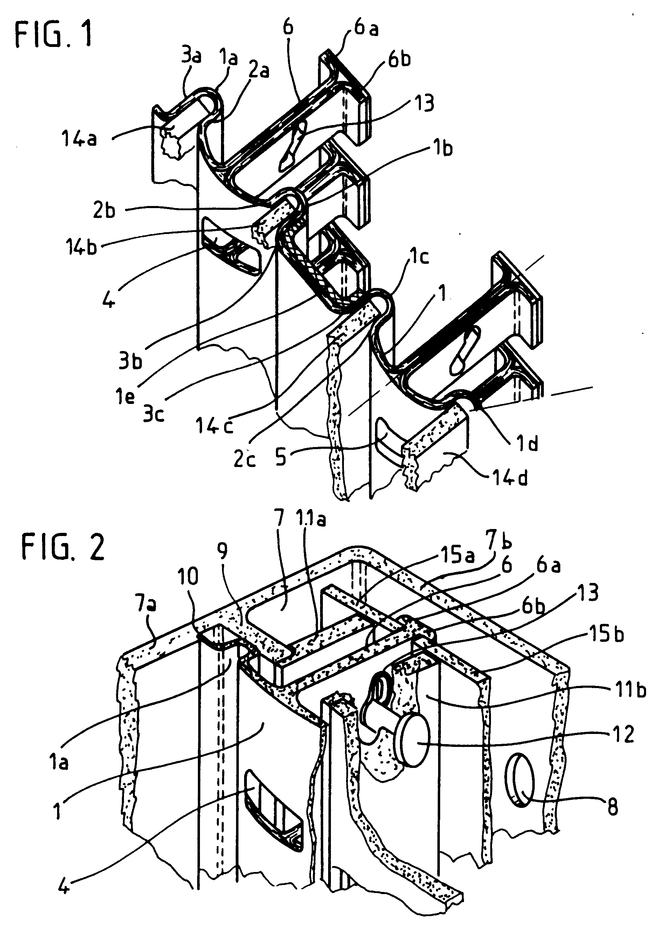

En référence à la figure 1, on a représenté en 1 un voile mince fabriqué en un matériau composite drapé à partir de tissu de carbone imprégné de résine thermodurcissable. Le voile 1 constitue une surface du type "développable", formée de génératrices rectilignes parallèles. A la figure 1 on a représenté quatre glissières successives 1a, 1b, 1c, 1d formant des replis à lèvres parallèles, respectivement 2a et 3a, 2b et 3b, 2c et 3c. Entre ces replis, le voile 1 est percé d'orifices, tels que ceux représentés en 4 et 5, pour laisser passer l'air de refroidissement.

Entre deux glissières, par exemple 1a et 1b ou 1c et 1d, le voile 1 présente une forme arquée dont le sommet, dans ses parties non percées, comporte des tirants 6 terminés par des tenons 6a et 6b, le tout étant drapé directement avec le voile 1. Il résulte de cette forme arquée qu'un déplacement concomitant de tous les tirants 6 disposés entre deux glissières, telles que 1a et 1b ou 1c et 1d, a pour effet d'aplatir la forme arquée et donc de repousser la lèvre 2a contre la lèvre 3a et la lèvre 2b contre la lèvre 3b (ou la lèvre 2c contre 3c) ce qui a pour conséquence de serrer et de maintenir les cartes de circuits imprimés 14b, 14c ou 14d engagées dans les glissières 1b, 1c, 1d.

Les lèvres 3b et 3c, par exemple, peuvent résister à cette poussée car elles sont soutenues par des portions du voile 1 qui sont planes et éventuellement renforcées par des surépaisseurs telles que 1e.

En se référant maintenant à la figure 2 on a représenté, vue de dessus, une portion d'angle d'un boîtier 7 limitée entre deux parois latérales 7a et 7b de celui-ci, le couvercle du boîtier ayant été retiré. La paroi 7b est l'une de celles par où arrive l'air de refroidissement, qui passe par des orifices tels que 8. La paroi 7a supporte le voile 1 qui est appuyé contre une cloison 9, solidaire de la paroi 7a et parallèle à la paroi 7b, ainsi que le long d'un embrèvement 10 de la paroi 7a. La cloison 9 est découpée au droit des tirants 6.

De part et d 'autre de chaque alignement de tirants entre deux glissières par exemple de l'alignement de tirants 6 entre les glissières 1a et 1b, est disposé un coulisseau 11 constitué de deux montants 11a et 11b reliés ensemble par des axes 12, formant une sorte d'échelle. Les axes 12 traversent chacun un tirant 6 par un trou oblong et incliné 13 de ce tirant, de sorte qu'en enfonçant le coulisseau 11, qui s'appuie le long de la cloison 9, les axes 12 coopérant avec les trous 13 déplacent les tirants 6 en direction de la paroi 7b, ce qui aplatit la forme arquée du voile 1 et provoque un serrage efficace de la carte 14b dans la glissière 1b comme on l'a indiqué en référence à la figure 1.

Une sécurité de verrouillage est éventuellement assurée par l'introduction de plaques de verrouillage 15a, 15b entre les tenons 6a et 6b et le coulisseau 11.

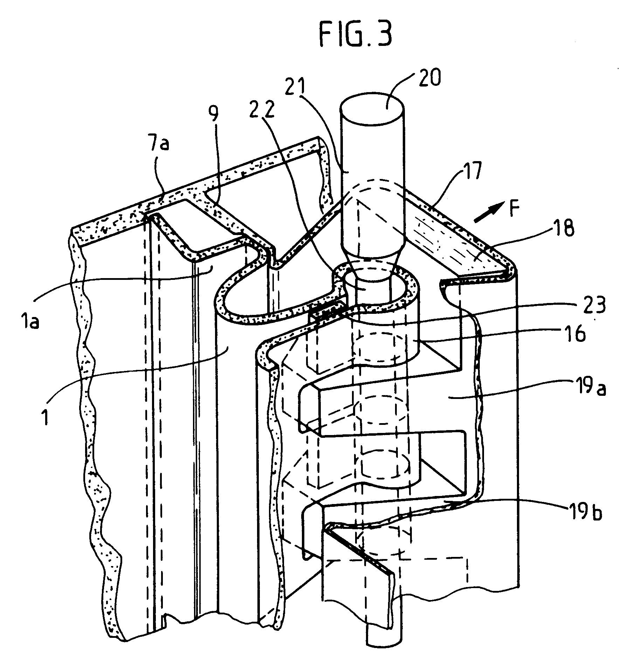

En référence à la figure 3, qui montre une autre forme d'exécution, la cloison 9 du boîtier 7 présente une forme ondulée pour recevoir les ondulations concomitantes 16 du voile 1 entre les glissières de ce dernier telles que 1a. Le fond de chacune des ondulations 17 de la cloison 9 est renforcé par une surépaisseur 18, laquelle porte de place en place sur sa longueur des tuteurs 19a, 19b proéminents qui se logent dans des interruptions des ondulations 16 du voile 1. Une tige de commande 20, comportant des renflements cylindriques tels que 21 raccordés progressivement à des parties de moindre diamètre 22, coulisse dans des trous de guidage des tuteurs permettant le passage des renflements tels que 21. Lorsqu'on enfonce la tige 20, ses parties renflées telles que 21 prennent appui d'une part contre les trous de guidage et d'autre part contre le fond des ondulations 16 du voile 1, ce qui déplace ces ondulations dans le sens de la flèche F. Ce déplacement des ondulations 16 du voile 1 écarte les lèvres 2, 3 de la glissière 1a, ainsi que celles de la glissière non représentée au dessin qui lui est symétrique par rapport aux ondulations 16 et 17.

On comprend alors que, en fonctionnement normal, la tige 20 est dans sa position représentée à la figure 3 (renflements 21 dégagés des ondulations 16) et les cartes de circuits imprimés sont maintenues en ayant leurs bords serrés dans les glissières. Pour le retrait de ces cartes ou la mise en place d'autres cartes, on annule ce serrage par un déplacement de la tige de commande 20 de façon que ses renflements 21 s'engagent dans les ondulations 16 comme expliqué au paragraphe précédent.

Des guides 23 peuvent avantageusement être implantés dans les ondulations 16 du voile 1 afin d'améliorer la tenue en vibration de ce dernier.

On comprendra que la description ci-dessus a été donnée à simple titre d'exemple. On comprendra en particulier que, dans la description qui précède, on a décrit le voile 1, comme étant réalisé en un matériau composite comprenant des fibres de carbone, mais qu'on aurait pu utiliser un matériau composite comprenant des fibres de verre, de bore ou de textile.

## Revendications

1. Dispositif de fixation de cartes de circuits imprimés dans un boîtier, comprenant des glissières parallèles (1a, 1b, 1c, 1d) constituées chacune de deux surfaces planes dites lèvres (2a,3a ; 2b,3b ; 2c,3c) qui peuvent recevoir les cartes (14a, 14b, 14c, 14d) par glissement, et des dispositifs de pincement (6, 11) qui permettent de serrer chacune des cartes (14a, 14b, 14c, 14d) le long de son bord entre les deux lèvres en vis-à-vis (2a,3a ; 2b,3b ; 2c,3c) de chacune des glissières (1a, 1b, 1c, 1d), caractérisé en ce que les glissières (1a, 1b, 1c, 1d) sont constituées par des replis de plaques ou voiles minces et souples (1), le boîtier (7) recevant deux de ces voiles (1) en vis à vis le long de deux de ses parois latérales.

2. Dispositif de fixation selon la revendication 1, caractérisé en ce que le serrage s'effectue, de part et d'autre du bord de la carte (14a, 14b, 14c, 14d) par rapprochement des lèvres (2a,3a ; 2b,3b ; 2c,3c) du repli formant glissière (1a, 1b, 1c, 1d) permis par la souplesse du voile mince (1), avec flexion de celui-ci au droit dudit repli.

3. Dispositif de fixation selon la revendication 2, caractérisé en ce que le repli (1a, 1b, 1c, 1d) laisse au repos entre les deux lèvres de glissière (2a,3a ; 2b,3b ; 2c,3c) un lèger jeu de part et d'autre de la carte (14a, 14b, 14c), et en ce que le voile (1) a une forme arquée entre deux glissières (1a,1b ; 1c,1d), un moyen d'aplatissement (6, 11) de cette forme arquée étant prévu pour repousser les lèvres de glissière (2a,2b) qui lui sont contiguës de façon à les rapprocher des lèvres (3a,3b) en vis à vis et créer un serrage simultané de deux cartes (14a, 14b) précédemment introduites dans les deux glissières (1a, 1b).

4. Dispositif de fixation selon la revendication 3, caractérisé en ce que ledit moyen d'aplatissement comprend des tirants (6) solidaires à une extrémité de la partie de forme arquée du voile (1) disposée entre deux glissières (1a,1b ; 1c,1d), et un coulisseau (11) portant des axes (12) qui traversent les tirants (6) par des trous oblongs et inclinés (13) de ces tirants (6).

5. Dispositif de fixation selon la revendication 4, caractérisé en ce que les tirants (6) portent des tenons (6a, 6b) qui sont verrouillés, en position de fixation des cartes (14a, 14b, 14c, 14d), au moyen de plaques de verrouillage (15a, 15b) insérées entre les dits tenons (6a, 6b) et une pièce de butée (11).

6. Dispositif de fixation selon la revendication 2, caractérisé en ce que le repli (1a) est fabriqué suffisamment étroit pour assurer au repos un serrage de ses lèvres (2, 3) sur les bords de la carte, des moyens (16, 20) étant prévus pour accentuer une forme arquée du voile (1) entre deux replis en écartant l'une de l'autre les deux lèvres (2, 3) en vis à vis pour permettre l'introduction ou le retrait de la carte.

7. Dispositif de fixation selon la revendication 6, caractérisé en ce que lesdits moyens d'accentuation de la forme arquée du voile (1) comprennent des ondulations (16) du voile (1), des ondulations (17) d'une cloison de support (9) qui sont concomitantes desdites ondulations (16) du voile (1) et un moyen (20) qui assure un rapprochement entre les fonds desdites ondulations concomitantes (16,17).

8. Dispositif selon l'une quelconque des revendications 1 à 7, caractérisé en ce que ledit voile mince (1) est en un matériau composite avec des fibres de carbone, de verre, de bore ou de textile.

9. Boîtier équipé d'un dispositif de fixation selon l'une quelconque des revendications 1 à 8, comportant une caisse parallélépipèdique munie d'un couvercle, d'un fond à l'opposé dudit couvercle et de côtés latéraux (7a, 7b), caractérisé en ce qu'il comprend deux voiles minces et souples (1) qui comportent des séries de replis (1a, 1b, 1c, 1d) dont chacun forme deux lèvres parallèles (2a,3a ; 2b,3b ; 2c,3c) aptes à recevoir entre elles un des bord d'une carte (14a, 14b, 14c), chaque voile (1) étant maintenu à proximité d'un des côtés de la caisse, à une distance de l'autre voile (1) correspondant à la largeur des cartes (14a, 14b, 14c) et des dispositifs de pincement (6, 11) permettant de serrer individuellement chaque bord de carte (14a, 14b, 14c) entre les lèvres parallèles (2a,3a ; 2b,3b ; 2,3c) de chaque repli (1a, 1b, 1c, 1d) de voile (1).

## Patentansprüche

1. Vorrichtung zur Befestigung von Leiterplatten in einem Gehäuse mit parallelen Gleitschienen (1a, 1b, 1c, 1d), die jeweils aus zwei, Lippen genannten, parallelen Flächen (2a, 3a; 2b, 3b; 2c, 3c) bestehen, die die Karten (14a, 14b, 14c, 14d) gleitend aufnehmen können, sowie mit Klemmeinrichtungen (6, 11), die es ermöglichen, jede der Karten (14a, 14b, 14c, 14d) längs ihres Randes zwischen den beiden gegenüberliegenden Lippen (2a, 3a; 2b, 3b; 2c) jeder Gleitschiene (1a, 1b, 1c, 1d) einzuklemmen, dadurch gekennzeichnet, daß die Gleitschienen (1a, 1b, 1c, 1d) durch Falze von dünnen und elastischen Platten oder Schürzen (1) gebildet sind, wobei das Gehäuse (7) zwei dieser gegenüberliegenden Schürzen (1) entlang seiner Seitenwände aufnimmt.

2. Befestigungsvorrichtung nach Anspruch 1, dadurch gekennzeichnet, daß das Einklemmen beiderseits des Randes der Karte (14a, 14b, 14c, 14d) durch Annäherung der Lippen (2a, 3a; 2b, 3b; 2c, 3c) des die Gleitschiene (1a, 1b, 1c, 1d) bildenden Falzes durchgeführt wird, was durch die Elastizität der dünnen Schürze (1) möglich wird, wobei diese auf Höhe des Falzes gebogen wird.

3. Befestigungsvorrichtung nach Anspruch 2, dadurch gekennzeichnet, daß der Falz (1a, 1b, 1c, 1d) in der Ruhestellung zwichen den beiden Lippen (2a, 3a; 2b, 3b; 2c, 3c) der Gleitschiene beiderseits der Karte (14a, 14b, 14c) ein leichtes Spiel läßt, und daß die Schürze (1) zwischen zwei Gleitschienen (1a, 1b; 1c, 1d) eine gewölbte Form aufweist, wobei ein Abflachungsmittel (6, 11) mit dieser gekrümmten Form vorgesehen ist, um die daran angrenzenden Gleitschienenlippen (2a, 2b) so zurückzudrücken, daß die gegenüberliegenden Lippen (3a, 3b) angenähert werden und gleichzeitig zwei Karten (14a, 14b) einklemmen, die vorher in die beiden Gleitschienen (1a, 1b) eingeführt wurden.

4. Befestigungsvorrichtung nach Anspruch 3, dadurch gekennzeichnet, daß das Abflachungsmittel Rippen (6) aufweist, die mit einem Ende des zwischen zwei Gleitschienen (1a, 1b; 1c, 1d) angeordneten Teils mit gewölbter Form fest verbunden sind, sowie ein Gleitstück (11) aufweist, das Achsen (12) trägt, die die Rippen (6) über Löcher (13) durchsetzen, die länglich und zu diesen Rippen (6) geneigt sind.

5. Befestigungsvorrichtung nach Anspruch 4, dadurch gekennzeichnet, daß die Rippen (6) Nasen (6a, 6b) tragen, die in Befestigungsposition für die Karten (14a, 14b, 14c, 14d) mittels Verriegelungsplatten (15a, 15b) verriegelt sind, die zwischen die Nasen (6a, 6b) und ein Anschlagstück (11) eingefügt sind.

6. Befestigungsvorrichtung nach Anspruch 2, dadurch gekennzeichnet, daß der Falz (1a) ausreichend eng hergestellt ist, um in der Ruhestellung ein Einklemmen seiner Lippen (2, 3) an den Rändern der Karte zu gewährleisten, wobei Mittel (16, 20) vorgesehen sind, um eine gewölbte Form der Schürze (1) zwischen zwei Falzen zu verstärken, wobei die beiden gegenüberliegenden Lippen (2, 3) voneinander entfernt werden, um das Einführen oder Herausziehen der Karte zu ermöglichen.

7. Befestigungsvorrichtung nach Anspruch 6, dadurch gekennzeichnet, daß die Mittel zum Verstärken der gewölbten Form der Schürze (1) gewellte Abschnitte (16) der Schürze (1), gewellte Abschnitte (17) einer Stützwand (9), die mit den gewellten Abschnitten (16) der Schürze (1) zusammenwirken, sowie ein Mittel (20) aufweisen, das eine Annäherung zwischen den Böden der zusammenwirkenden gewellten Abschnitte (16, 17) gewährleistet.

8. Vorrichtung nach einem der Ansprüche 1 bis 7, dadurch gekennzeichnet, daß die dünne Schürze (1) aus einem Verbundmaterial mit Carbon-, Glas- Bor- oder Textilfasern besteht.

9. Gehäuse, das mit einer Befestigungsvorrichtung nach einem der Ansprüche 1 bis 8 ausgestattet ist, mit einem quaderförmigen Kasten, der mit einem Deckel, einem dem Boden entgegengesetzt gelegenen Boden und Seitenwänden (7a, 7b) ausgestattet ist, dadurch gekennzeichnet, daß es zwei dünne und elastische Schürzen (1) aufweist, die Reihen von Falzen (1a, 1b, 1c, 1d) aufweisen, von denen jeder zwei parallele Lippen (2a, 3a; 2b, 3b; 2c, 3c) ausbildet, die zur Aufnahme eines der Ränder einer Karte (14a, 14b, 14c) zwischen ihnen geeignet sind, wobei jede Schürze (1) in der Nähe einer der Seiten des Kastens im einem Abstand von der anderen Schürze (1) gehalten wird, der der Breite der Karten (14a, 14b, 14c) entspricht, und Klemmeinrichtungen (6, 11) das individuelle Einklemmen jedes Randes der Karte (14a, 14b, 14c) zwischen den parallelen Lippen (2a, 3a; 2b, 3b; 2c, 3c) jedes Falzes (1a, 1b, 1c, 1d) der Schürze (1) ermöglichen.

## Claims

1. Device for securing printed circuit boards in a case comprising parallel slide ways (1a, 1b, 1c, 1d) each consisting of two flat surfaces known as lips (2a, 3a; 2b, 3b; 2c, 3c) which can accommodate the boards (14a, 14b, 14c, 14d) by sliding, and clamping devices (6, 11) which enable each of the boards (14a, 14b, 14c, 14d) to be clamped along its edge between the two opposite lips (2a, 3a; 2b, 3b; 2c, 3c) of each of the slide ways (1a, 1b, 1c, 1d), characterised in that the slide ways (1a, 1b, 1c, 1d) consist of folds of thin, flexible plates or sheets (1), the case (7) accommodating two of these sheets (1) opposite one another along two of its side walls.

2. Securing device according to Claim 1, characterised in that clamping is brought about on either side of the board (14a, 14b, 14c, 14d) by moving towards each other the lips (2a, 3a; 2b, 3b; 2c, 3c) of the fold forming the slide way (1a, 1b, 1c, 1d) permitted by the flexibility of the thin sheet (1), the latter bending perpendicular to the fold.

3. Securing device according to Claim 2, characterised in that, in the rest state, the fold (1a, 1b, 1c, 1d) leaves a slight clearance on either side of the board (14a, 14b, 14c) between the two lips of the slide way (2a, 3a; 2b, 3b; 2c, 3c); and in that the sheet (1) is arcuate between two slide ways (1a, 1b; 1c, 1d), a means (6, 11) for flattening this arcuate shape being provided in order to push back the slide way lips (2a, 2b) which are contiguous therewith so as to move them closer to the opposite lips (3a, 3b) and to create simultaneous clamping of two boards (14a, 14b) previously introduced into the two slide ways (1a, 1b).

4. Securing device according to Claim 3, characterised in that the flattening means comprises tension pieces (6) integral at one end with the arcuate portion of the sheet (1) disposed between two slide ways (1a, 1b; 1c, 1d), and a slide (11) supporting pins (12) which pass through the tension pieces (6) via oblong and inclined holes (13) in these tension pieces (6).

5. Securing device according to Claim 4, characterised in that the tension pieces (6) carry tenons (6a, 6b) which are locked, in the position for securing the boards (14a, 14b, 14c, 14d), by means of locking plates (15a, 15b) inserted between the tenons (6a, 6b) and a stop part (11).

6. Securing device according to Claim 2, characterised in that the fold (1a) is manufactured sufficiently narrowly to ensure, in the rest state, that its lips (2, 3) are clamped on the edges of the board, means (16, 20) being provided in order to accentuate an arcuate shape of the sheet (1) between two folds by moving the two opposite lips (2, 3) away from one another so as to enable the board to be introduced or withdrawn.

7. Securing device according to Claim 6, characterised in that the means for accentuating the arcuate shape of the sheet (1) comprise undulations (16) of the sheet (1), undulations (17) of a support partition (9) which are associated with the undulations (16) of the sheet (1) and a means (20) which draws the bases of the associated undulations (16, 17) close to one another.

8. Device according to any one of Claims 1 to 7, characterised in that the thin sheet (1) is made of a composite material with carbon, glass, boron or textile fibres.

9. Case equipped with a securing device according to any one of Claims 1 to 8, comprising a parallelepipedal casing provided with a cover, a base opposite the cover and lateral sides (7a, 7b), characterised in that it comprises two thin, flexible sheets (1) which comprise series of folds (1a, 1b, 1c, 1d) each of which forms two parallel lips (2a, 3a; 2b, 3b; 2c, 3c) which can receive therebetween one of the edges of a board (14a, 14b, 14c), each sheet (1) being held in the vicinity of one of the edges of the casing, at a distance from the other sheet (1) corresponding to the width of the boards (14a, 14b, 14c) and clamping devices (6, 11) enabling each edge of the board (14a, 14b, 14c) to be clamped individually between the parallel lips (2a, 3a; 2b, 3b; 2c, 3c) of each fold (1a, 1b, 1c, 1d) of the sheet (1).
